(19) Europäisches Patentamt
European Patent Office
Office européen des brevets

(11) **EP 4 498 157 A2**

(12) **EUROPEAN PATENT APPLICATION**

(43) Date of publication:
**29.01.2025  Bulletin 2025/05**

(21) Application number: **24189050.8**

(22) Date of filing: **17.07.2024**

(51) International Patent Classification (IPC):
**G03F 7/00** *(2006.01)*      **G03F 9/00** *(2006.01)*

(52) Cooperative Patent Classification (CPC):
**G03F 7/70633; G03F 9/7046**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.07.2023  JP 2023120185
24.07.2023  JP 2023120186
26.02.2024  JP 2024026912**

(71) Applicant: **CANON KABUSHIKI KAISHA
Tokyo 146-8501 (JP)**

(72) Inventors:
• **KIZU, Fuma**
  **Tokyo (JP)**
• **HARA, Tokuo**
  **Tokyo (JP)**
• **MIZUMOTO, Kazushi**
  **Tokyo (JP)**

(74) Representative: **WESER & Kollegen
Patentanwälte PartmbB
Radeckestraße 43
81245 München (DE)**

(54) **LITHOGRAPHY METHOD, ARTICLE MANUFACTURING METHOD, INFORMATION PROCESSING METHOD, COMPUTER PROGRAM, AND INFORMATION PROCESSING APPARATUS**

(57)     A lithography method of forming, on a substrate, a plurality of layers including a first layer including a first pattern, a second layer including a second pattern, and a third layer, is provided. The method includes detecting relative position information indicating relative position between the first pattern and the second pattern in aligning the substrate and an original for patterning of the third layer. The method also includes collecting the relative position information obtained in the detecting.

**F I G.  4**

START
REGISTER — S401
LOAD SUBSTRATE — S402
CALIBRATION — S403
PREALIGNMENT — S404
CAPTURE IMAGE OF SAMPLE SHOT REGION MARK — S405
CALCULATE MARK POSITION — S406
CALCULATE RELATIVE POSITION — S407
END ? — S408
NO / YES
CALCULATE ARRANGEMENT OF ALL SHOT REGIONS OF SUBSTRATE — S409
ALIGNMENT AND EXPOSURE FOR ALL SHOT REGIONS — S410
UNLOAD SUBSTRATE — S411
ADJUSTMENT — S412
END

## Description

BACKGROUND OF THE INVENTION

Field of the Invention

The present invention relates to a lithography method, an article manufacturing method, an information processing method, a computer program, and an information processing apparatus.

Description of the Related Art

Along with recent miniaturization and high integration of devices, a requirement for improvement of overlay accuracy is increasing. In a lithography apparatus such as an exposure apparatus, alignment between a substrate and an original is performed using an alignment mark provided in a shot region of the substrate, and the accuracy of the alignment can appear in the overlay accuracy. Japanese Patent No. 5194800 describes that in a system including an exposure apparatus and a measurement device, an overlay error between a first pattern on an object and a second pattern on the first pattern is actually measured by the measurement device, and an optimization step is executed based on the actual measurement result. The optimization step includes a first sub-step of detecting an abnormality of overlay accuracy, and a second sub-step of, if an abnormality is detected, optimizing a processing condition based on a correlation relationship between the actually measured value of the overlay error and the processing condition of alignment processing.

In general, an overlay error can be measured using an overlay measurement device after a pattern is formed on a substrate using a lithography apparatus. Here, measuring an overlay error in all substrates is advantageous in improving the overlay accuracy but is disadvantageous from the viewpoint of cost. On the other hand, measuring an overlay error only in sampled substrates is advantageous from the viewpoint of cost but is disadvantageous in improving the overlay accuracy.

SUMMARY OF THE INVENTION

The present invention provides a technique advantageous in improving the overlay accuracy while suppressing cost.

The present invention in its first aspect provides a lithography method as specified in claims 1 to 14.

The present invention in its second aspect provides a lithography method as specified in claim 15.

The present invention in its third aspect provides an article manufacturing method as specified in claim 16.

The present invention in its fourth aspect provides an information processing method as specified in claim 17.

The present invention in its fifth aspect provides an information processing method as specified in claim 18.

The present invention in its sixth aspect provides a computer program as specified in claim 19.

The present invention in its seventh aspect provides an information processing apparatus as specified in claim 20 and 21.

Further features of the present invention will become apparent from the following description of exemplary embodiments with reference to the attached drawings.

BRIEF DESCRIPTION OF THE DRAWINGS

Fig. 1A is a view showing an example of the configuration of an exposure apparatus according to an embodiment;
Fig. 1B is a view showing an example of the configuration of a position measurement device;
Figs. 2A and 2B are views exemplifying an array of a plurality of shot regions of a substrate;
Fig. 3A is a plan view showing an example of the configuration of a mark that can be provided in a shot region;
Fig. 3B is a sectional view showing an example of the configuration of a mark that can be provided in a shot region;
Fig. 4 is a flowchart exemplifying a lithography method according to the first embodiment;
Fig. 5 is a view showing a first example of the operation of the lithography method;
Fig. 6 is a view showing a second example of the operation of the lithography method;
Fig. 7 is a view showing a third example of the operation of the lithography method;
Fig. 8 is a flowchart exemplifying a lithography method according to the second embodiment;
Fig. 9 is a flowchart exemplifying the procedure of a lithography method of forming a plurality of layers on a substrate according to the second embodiment;
Figs. 10A to 10C are views for explaining processing of detecting the position of a mark based on the positions of a first pattern and a second pattern forming the mark; and
Fig. 11 is a view showing an application example.

DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

(First Embodiment)

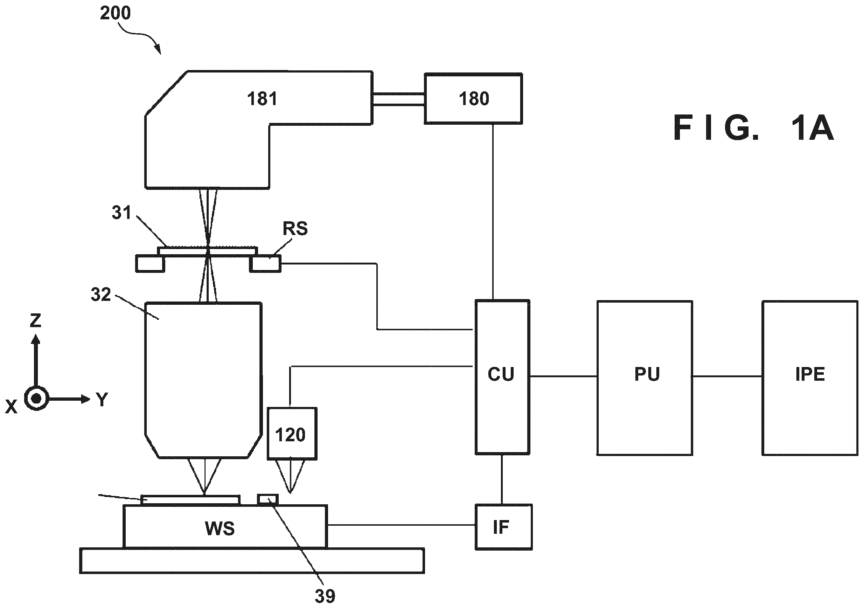

Fig. 1A shows the configuration of an exposure apparatus 200 according to an embodiment. The exposure apparatus 200 is an example of a lithography apparatus that transfers the pattern of an original 31 to a substrate 83 in an article manufacturing method of manufacturing an article or a device such as a semiconductor element or a liquid crystal display element. The lithography apparatus may be, for example, an imprint apparatus or another pattern forming apparatus such as an electron beam lithography apparatus. The exposure apparatus 200 projects the pattern of the original 31 to the substrate 83 to which a photoresist is applied, thereby transferring the pattern of the original 31 as a latent image to the photoresist.

The exposure apparatus 200 serving as a lithography apparatus can be used to pattern at least one layer of a plurality of layers in a lithography method of forming the plurality of layers on the substrate 83. The plurality of layers can include, for example, a first layer including a first pattern, a second layer including a second pattern, and a third layer. In an example, the exposure apparatus 200 is configured to transfer the pattern of the original 31 to the substrate 83 having the first layer including the first pattern, the second layer including the second pattern, and the third layer. The exposure apparatus 200 exposes, via the original 31, a photoresist applied to the substrate 83, thereby transferring the pattern of the original 31 as a latent image to the photoresist. When the photoresist is developed, a resist pattern is formed. An underlying layer (for example, the third layer) is etched using the resist pattern, thereby forming a pattern according to the resist pattern on the underlying layer.

In this embodiment, the exposure apparatus 200 employs a step-and-scan method, but may employ another exposure method such as a step-and-repeat method. As exemplified in Fig. 1A, the exposure apparatus 200 can include an illumination optical system 181, an original stage RS that holds the original 31, a projection optical system 32, a substrate stage WS that holds the substrate 83, a position measurement device 120, and a controller CU. The controller CU may be connected to an individual information processing apparatus PU and also to a shared information processing apparatus IPE.

The illumination optical system 181 is an optical system that illuminates the original 31 using light from a light source unit 180. The light source unit 180 includes, for example, a laser. The laser can be an ArF excimer laser having a wavelength of about 193 nm or a KrF excimer laser having a wavelength of about 248 nm, but the type of light source is not limited to the excimer laser. For example, the light source unit 180 may use, as the light source, an F2 laser having a wavelength of about 157 nm or extreme ultraviolet (EUV) having a wavelength of 20 nm or less.

The illumination optical system 181 can be configured to shape the light from the light source unit 180 into slit light having a predetermined shape suitable for exposure and illuminate the original 31 with the slit light. The illumination optical system 181 has a function of uniformly illuminating the original 31 and a polarizing illumination function. The illumination optical system 181 includes, for example, a lens, a mirror, an optical integrator, and a stop, and is formed by arranging a condenser lens, a fly-eye lens, an aperture stop, a condenser lens, a slit, and an imaging optical system in this order.

The original 31 is made of, for example, quartz. A pattern (for example, a circuit pattern) to be transferred to the substrate 83 is formed on the original 31. The original stage RS holds the original 31 via an original chuck (not shown). The original stage RS is driven by an original driving mechanism (not shown). The original driving mechanism includes a linear motor, and the like, and can move the original 31 held by the original stage RS by driving the original stage RS in the X-axis direction, the Y-axis direction, the Z-axis direction, and the rotation directions around the respective axes. Note that the position of the original 31 is measured by the original position measurement unit (not shown) of a light oblique-incidence system, and the position of the original 31 can be controlled based on the measurement result.

The projection optical system 32 has a function of imaging the light from an object plane (original 31) in an image plane (substrate 83). The projection optical system 32 projects the light (diffracted light) having passed through the pattern of the original 31 onto the substrate 83, thereby transferring the pattern of the original 31 to the photoresist on the substrate 83. As the projection optical system 32, an optical system formed from a plurality of lens elements, an optical system (catadioptric optical system) including a plurality of lens elements and at least one concave mirror, an optical system including a plurality of lens elements and at least one diffractive optical element such as kinoform, or the like is used.

The substrate 83 is a processing target object to which the pattern of the original 31 is transferred. The substrate 83 can be, for example, a wafer, a liquid crystal substrate, or another member. The substrate stage WS holds the substrate 83 via a substrate chuck (not shown), and is driven by a substrate driving mechanism (not shown). The substrate driving mechanism includes a linear motor, and the like, and can move the substrate 83 held by the substrate stage WS by driving the substrate stage WS in the X-axis direction, the Y-axis direction, the Z-axis direction, and the rotation directions around the respective axes. Furthermore, a reference plate 39 is provided on the substrate stage WS.

The position of the original stage RS and the position of the substrate stage WS are monitored by, for example, a 6-axis interferometer IF or the like, and the original stage RS and the substrate stage WS can be driven at a constant speed ratio under the control of the controller CU.

The controller CU is formed by a computer (information processing apparatus) including a CPU and a memory and, for example, operates the exposure apparatus 200 by comprehensively controlling the respective units of the exposure apparatus 200 in accordance with a program stored in a storage unit. The controller CU, for example, controls exposure processing of transferring the pattern of the original 31 to the substrate 83 by exposing the substrate 83 via the original 31. Furthermore, the controller CU may execute measurement processing using the position measurement device 120 and correction processing (calculation processing) of correcting a measurement value obtained by the measurement processing. That is, the controller CU may function as a part of the position measurement device 120, that is, the whole or a part of the processor of the position measurement device 120.

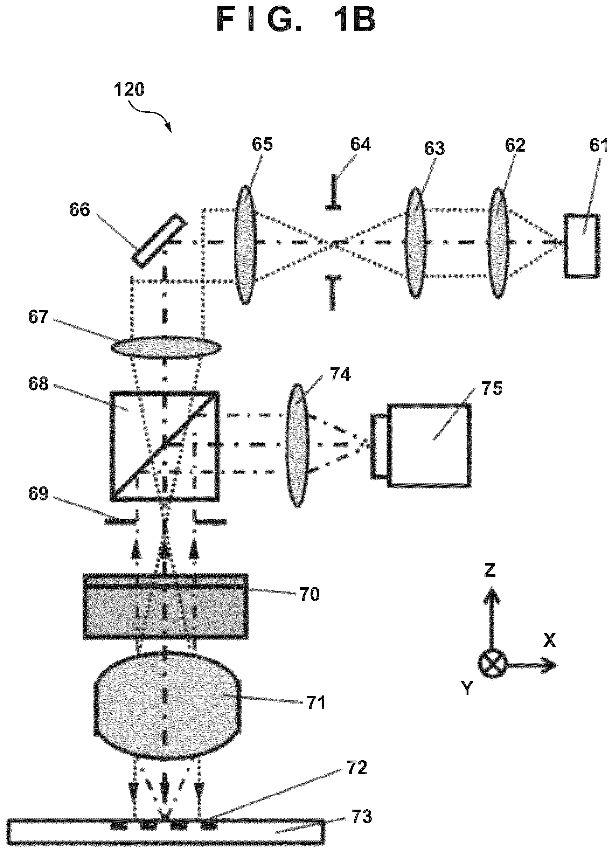

Fig. 1B shows an example of the configuration of the position measurement device 120. The position measurement device 120 can be called an alignment scope. The position measurement device 120 can include an illumination system that illuminates the substrate 83, an image sensor 75, and an imaging system that images light from the mark 72 of the substrate 83 onto the image sensor 75. In the example shown in Fig. 1B, the position measurement device 120 includes constituent elements shared by the illumination system and the imaging system.

The illumination system will be described first. Light from a light source 61 is guided to an illumination aperture stop 64 via illumination optical systems 62 and 63. The light having passed through the illumination aperture stop 64 is guided to a polarization beam splitter 68 via an illumination optical system 65, a mirror 66, and an illumination optical system 67. The polarization beam splitter 68 transmits P-polarized light parallel to the X direction and reflects S-polarized light parallel to the Y direction. The P-polarized light transmitted through the polarization beam splitter 68 passes through an aperture stop 69, and is then converted into circularly polarized light by a $\lambda/4$ plate 70, thereby Koehler-illuminating, via an objective optical system 71, the mark 72 formed on the substrate 83.

The illumination system may include a light quantity adjuster (not shown) and/or a wavelength adjuster (not shown). For example, the light quantity adjuster is configured to arrange, in an optical path from the light source 61, an ND filter selected from a plurality of ND filters having different transmittances, thereby making it possible to adjust the intensity of light illuminating the substrate 83. The wavelength adjuster is configured to arrange, in the optical path from the light source 61, a plurality of wavelength filters which transmit light beams having different wavelength characteristics, thereby making it possible to adjust the wavelength of light illuminating the substrate 83.

The imaging system will be described below. The light reflected, diffracted, and scattered by the mark 72 on the substrate 83 passes through the objective optical system 71 and the $\lambda/4$ plate 70 and is guided to the aperture stop 69. The polarization state of the light from the mark 72 is circular polarization that is reverse to the circular polarization of the light illuminating the mark 72. Therefore, if the polarization state of the light illuminating the mark 72 is clockwise circular polarization, the polarization state of the light from the mark 72 is counterclockwise circular polarization. The light converted from circular polarization into S-polarization by the $\lambda/4$ plate 70 passes through the aperture stop 69, is reflected by the polarization beam splitter 68, and is guided to the image sensor 75 via an imaging optical system 74.

As described above, in the position measurement device 120, the polarization beam splitter 68 separates the optical path of the light illuminating the substrate 83 and the optical path of the light from the substrate 83, and an image of the mark 72 on the substrate 83 is formed in the image sensor 75. Based on a signal waveform obtained by detecting the image of the mark 72, the controller CU can determine or acquire the position of the mark 72 in the coordinate system of the position measurement device 120. The intensity of the signal waveform from the mark 72 can be adjusted by, for example, the light quantity adjuster (ND filter) provided in the illumination system of the position measurement device 120, the output control of the light source 61, and control of the accumulation time of the image sensor 75. Based on the position of the substrate stage WS obtained using the laser interferometer IF and the position of the mark 72 in the coordinate system of the position measurement device 120, the controller CU can determine and acquire the position of the mark 72 in the coordinate system of the substrate stage WS.

In the imaging system of the position measurement device 120, a detection aperture stop may be arranged between the polarization beam splitter 68 and the image sensor 75. Furthermore, it may be possible to adjust the numerical aperture of each of the illumination aperture stop 64 and the detection aperture stop, thereby adjusting a $\sigma$ value which is a coefficient representing the ratio of the numerical aperture of the illumination system and the numerical aperture of the imaging system. An example of a mechanism for adjusting the numerical aperture is a configuration in which an aperture stop arbitrarily selected from a plurality of aperture stops can be arranged in the optical path.

The position measurement device 120 can be configured to detect, by the image sensor 75, light (reflected light and scattered light) from the mark 72, or each of a first pattern P1 and a second pattern P2 forming the mark 72. As a method of detecting the light from the mark 72, for example, dark field detection can be adopted in which the aperture stop 64 and the detection aperture stop (the numerical apertures of the illumination system and the imaging system) are controlled to block the 0-order diffracted light from the mark 72 and detect only the higher-order diffracted light and scattered light.

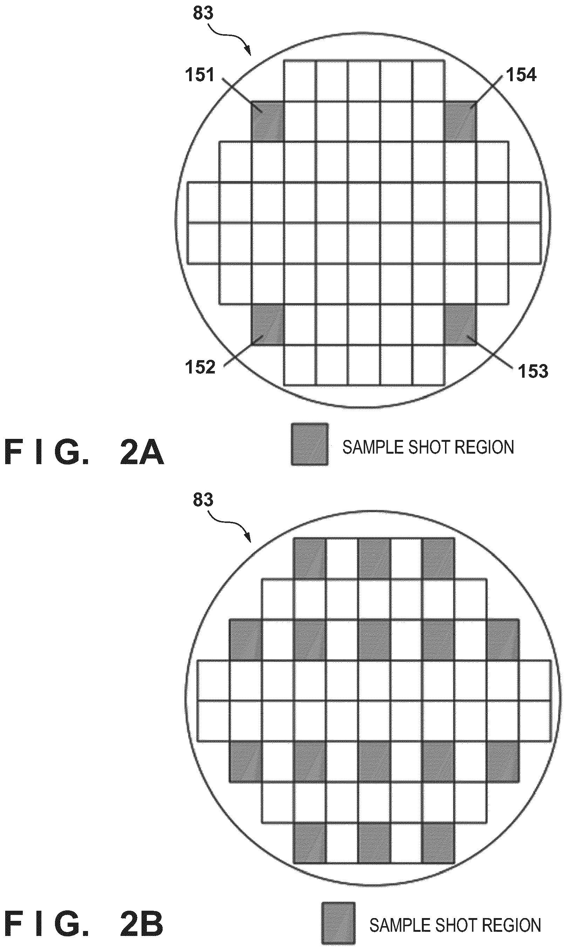

Figs. 2A and 2B each show an example of the array of the plurality of shot regions of the substrate 83. In the example shown in Fig. 2A, among the plurality of shot regions of the substrate 83, shot regions for which measurement processing (alignment measurement) is performed, that is, sample shot regions are shot regions 151 to 154. In the peripheral portion of the shot region, a scribe line (not shown) is arranged. If each shot region includes a plurality of chip regions (regions chipped by dicing), a scribe line (not shown) is arranged between adjacent chip regions. A mark (not shown) is arranged on each scribe line. Fig. 2B shows an example in which the number of sample shot regions is increased. A mark is provided in each of the shot regions (including the sample shot regions).

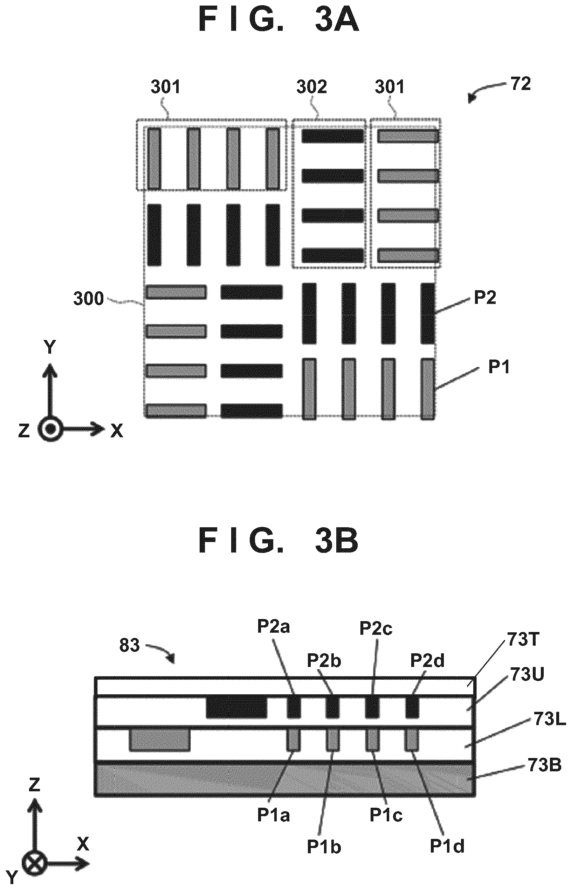

Figs. 3A and 3B are a plan view and a sectional view, respectively, exemplifying the mark 72 provided in each of the shot regions (including the sample shot regions). The mark 72 can include the first pattern P1 arranged in a first layer 73L on a base 73B of the substrate 83, and the second pattern P2 arranged in a second layer 73U different from the first layer 73L. In this example, the second layer 73U is arranged on the first layer 73L. The first pattern P1 and the second pattern P2 can be arranged to be simultaneously fitted in the visual field of the position measurement device 120 (alignment scope). The mark 72 serves as an alignment mark configured to align the original 31 used for patterning of a third layer 73T on the second layer 73U. The target of alignment of the original 31 used for patterning of the third layer 73T may be the first layer 73L or the second layer 73U, or may be the first layer 73L and the second layer 73U. In the example shown in Figs. 3A and 3B, the first pattern P1 arranged in the first layer 73L includes, for example, four pattern elements (mark elements) P1a, P1b, P1c, and P1d, and the second pattern P2 arranged in the second layer 73U includes four pattern elements (mark elements) P2a, P2b, P2c, and P2d.

Only a part of the mark 72 may be used as the alignment mark for alignment of the original 31 used for patterning of the third layer 73T. For example, only the first pattern P1 of the mark 72 may be used as the alignment mark for alignment of the original 31 used for patterning of the third layer 73T, and in this case, the target of alignment of the original 31 is the first layer 73L. Alternatively, only the second pattern P2 of the mark 72 may be used as the alignment mark for alignment of the original 31 used for patterning of the third layer 73T, and in this case, the target of alignment of the original 31 is the second layer 73U.

Alternatively, both the first pattern P1 and the second pattern P2 may be used as the alignment mark for alignment of the original 31 used for patterning of the third layer 73T. In this case, the target of alignment of the original 31 includes the first layer 73L and the second layer 73U.

The mark 72 also serves as an overlay measurement mark configured to measure an overlay error. For example, the mark 72 may be used to detect the relative position between the first pattern P1 and the second pattern P2 in an alignment step of aligning the substrate 83 and the original 31 for patterning of the third layer 73T. Alternatively, a detection step may be executed after the alignment step based on an image obtained by capturing an image of the first pattern P1 and the second pattern P2 in the alignment step of aligning the substrate 83 and the original 31 for patterning of the third layer 73T. The detection step can be performed to detect the relative position between the first pattern P1 and the second pattern P2 in the exposure apparatus 200 or another apparatus. In this case as well, processing of capturing an image of the overlay measurement mark in an overlay measurement apparatus different from the exposure apparatus after patterning of the third layer is unnecessary, as in a conventional method. The other apparatus can be the individual information processing apparatus PU that is a dedicated information processing apparatus connected to the exposure apparatus 200, or the shared information processing apparatus IPE that is an information processing apparatus shared by a plurality of exposure apparatuses 200. Note that the individual information processing apparatus PU may be understood as a constituent element of the exposure apparatus 200.

Using the mark 72 not only as an alignment mark but also as an overlay measurement mark is advantageous in reducing an overcrowded state of marks on scribe lines or making the width of a scribe line small and improving yield.

In the mark 72, the first pattern P1 can include a plurality of first portions 301, and the second pattern P2 can include a plurality of second portions 302. In one viewpoint, the overlay measurement mark can have a feature that the second pattern P2 is fitted in a rectangular region 300 circumscribed on the first pattern P1. In another viewpoint, in the mark 72, at least a part of at least one of the plurality of second portions 302 can be arranged between at least two first portions 301 of the plurality of first portions 301.

In the alignment step, the position measurement device 120 can execute position measurement of the mark 72 for alignment of the original 31 for at least one of the first layer 73L and the second layer 73U. Also, in the alignment step, the position measurement device 120 can execute the detection step of detecting the relative position between the first pattern P1 and the second pattern P2. Alternatively, the position measurement device 120 may provide the image of the mark 72 captured in the alignment step to another apparatus (for example, the individual information processing apparatus PU or the shared information processing apparatus IPE) to allow the other apparatus to execute the detection step.

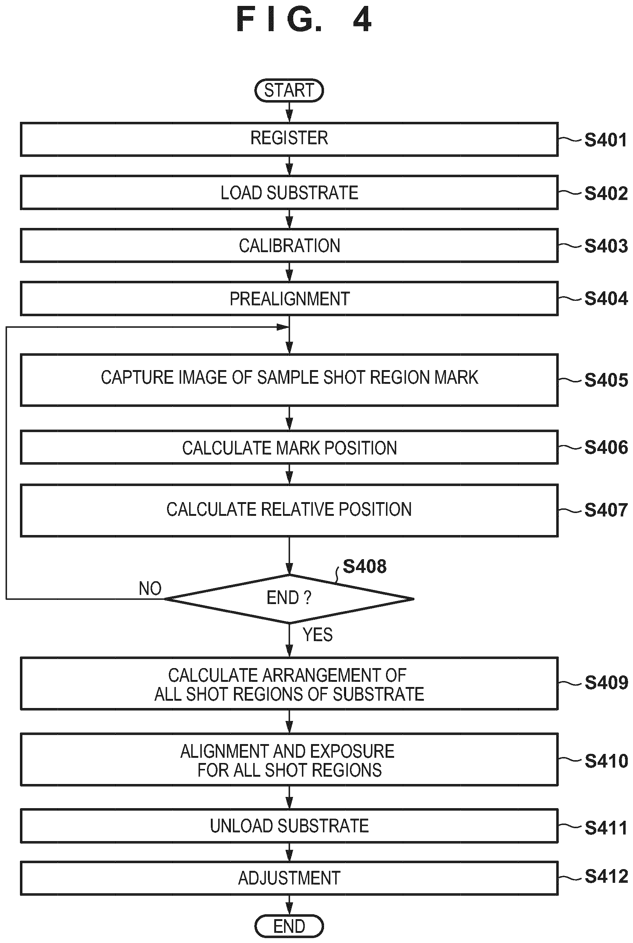

Fig. 4 exemplifies a lithography method for performing exposure for patterning of the third layer 73T (exposure of a photoresist film on the third layer) of the substrate 83 including the unpatterned third layer 73T on the first layer 73L and the second layer 73U which are patterned. Step S401 is a registration step. In the registration step, the first pattern P1 and the second pattern P2, whose relative position should be detected in the detection step (step S405 and S407) of the alignment step (step S405 to S410), are registered in the exposure apparatus 200 used for patterning of the third layer 73T. The registration step may include a step of registering a mark (the first pattern P1 and/or the second pattern P2) used for alignment between the substrate 83 and the original 31 in the alignment step. In the registration step, as the first pattern P1 and the second pattern P2, marks arranged to be simultaneously fitted in the visual field of the position measurement device 120 (alignment scope) in the exposure apparatus 200 used for patterning of the third layer 73T can be registered. The registration step can be executed by the controller CU, the individual information processing apparatus PU, or the shared information processing apparatus IPE.

In step S402, the substrate 83 is loaded onto the substrate stage WS of the exposure apparatus 200 under the control of the controller CU. In step S403, calibration is performed under the control of controller CU. More specifically, based on the designed coordinate position of the reference mark provided on the reference plate 39 on the coordinate system of the substrate stage WS, the substrate stage WS is driven such that the reference mark is located on the optical axis of the position measurement device 120. Next, the position deviation of the reference mark with respect to the optical axis of the position measurement device 120 is measured, and based on the position deviation, the coordinate system of the substrate stage WS is set again such that the origin of the coordinate system of the substrate stage WS matches the optical axis of the position measurement device 120. Next, based on the designed positional relationship between the optical axis of the position measurement device 120 and the optical axis of the projection optical system 32, the substrate stage WS is driven such that the reference mark is located on the optical axis of exposure light. Then, a through-the-lens (TTL) measurement system (not shown) measures, via the projection optical system 32, the position deviation of the reference mark with respect to the optical axis of the exposure light. Based on the result above, a baseline that is the interval between the optical axis of the position measurement device 120 and the optical axis of the projection optical system 32 is determined.

In step S404, prealignment of the substrate 83 can be executed under the control of the controller CU. Prealignment is performed using, for example, a scope (not shown) of a low magnification, and the mark 72 can thus be fitted in the visual field of the position measurement device 120. In steps S405 to S409, an alignment step (global alignment step) can be executed under the control of the controller CU. More specifically, in step S405, the position measurement device 120 captures an image of the mark 72 in a preset sample shot region among all shot regions of the substrate 83. In step S406, the controller CU can calculate (determine) the position of the mark 72 based on the image of the mark 72 captured in step S405. The position of the mark 72 can be determined based on at least one of the position of the first pattern P1 and the position of the second pattern P2. When determining the position of the mark 72 based on both the position of the first pattern P1 and the position of the second pattern P2, the position of the mark 72 can be determined based on, for example, not only the position of the first pattern P1 and the position of the second pattern P2 but also preset relative position information. The relative position information can be, for example, information representing the designed relative position between the first pattern P1 and the second pattern P2.

Steps S405 and S407 form a detection step in the alignment step. In step S407, the controller CU can calculate (determine) the relative position between the first pattern P1 and the second pattern P2 based on the image of the mark 72 captured in step S405. Step S407 may be executed by the individual information processing apparatus PU or the shared information processing apparatus IPE by transferring the image of the mark 72 captured in step S405 to the individual information processing apparatus PU or the shared information processing apparatus IPE. In the individual information processing apparatus PU or the shared information processing apparatus IPE, step S407 can be executed at an arbitrary timing in steps S406 to S413. The individual information processing apparatus PU and the shared information processing apparatus IPE can each be formed by, for example, a computer including a CPU and a memory. Each of the individual information processing apparatus PU and the shared information processing apparatus IPE can operate as an apparatus having a target function by loading a computer program into the memory and operating in accordance with the computer program. Each of the individual information processing apparatus PU and the shared information processing apparatus IPE can be understood as an information processing apparatus that executes an information processing method including step S407 (detection step) based on the image of the mark 72 captured in step S405. The information processing method may further include step S401 (registration step). Also, the information processing method may further include step S412 (adjustment step) to be described later.

In step S408, the controller CU judges whether steps S405 to S407 are executed for all the plurality of preset sample shot regions. If there remains a sample shot region for which steps S405 to S407 have not been executed, the controller CU executes steps S405 to S407 for the sample shot region.

In step S409, the controller CU performs global alignment of calculating the arrangement of all shot regions of the substrate 83 based on the position of the mark 72 calculated in step S406 for the plurality of preset sample shot regions. In step S410, the controller CU aligns each shot region of the substrate 83 and the original 31 based on the result of global alignment in step S409, and exposes the shot region (transfers the pattern of the original). At this time, alignment between the substrate 83 (shot region) and the original 31 can be performed based on at least one of the position of the first pattern P1 and the position of the second pattern P2. In step S411, the substrate 83 is unloaded under the control of the controller CU. When performing processing for a lot formed by a plurality of substrates 83 as a unit, steps S402 to S411 can be executed for the plurality of substrates.

Step S412 can be executed by the individual information processing apparatus PU or the shared information processing apparatus IPE. In step S412, an adjustment step of adjusting at least one of the lithography apparatus used for patterning of the first layer 73L and the lithography apparatus used for patterning of the second layer 73U can be executed based on the result obtained in step S407 (detection step). In the adjustment step, simply, adjustment information for adjusting at least one of the lithography apparatus used for patterning of the first layer 73L and the lithography apparatus used for patterning of the second layer 73U may be generated based on the result obtained in step S407. The adjustment step can be executed to reduce the overlay error between the first layer 73L, the second layer 73U, and the third layer 73T. In the adjustment step, an offset value used to adjust a patterning operation in at least one of the lithography apparatus used for patterning of the first layer 73L and the lithography apparatus used for patterning of the second layer 73U can be adjusted.

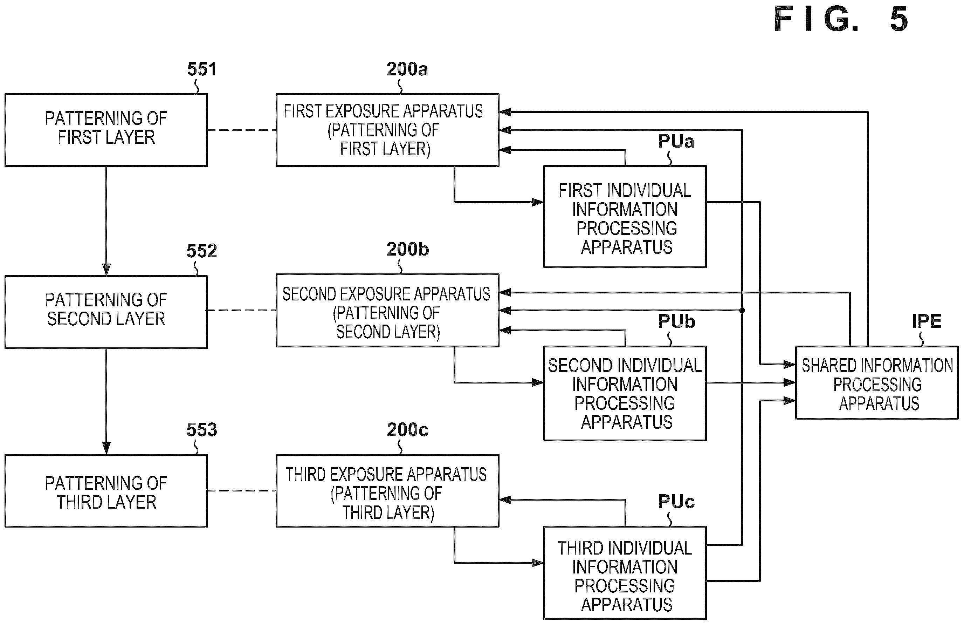

Fig. 5 schematically shows a first example of the operation of the lithography method including patterning of the first layer, the second layer, and the third layer. In the first example, patterning 551 of the first layer 73L is performed using a first exposure apparatus 200a, patterning 552 of the second layer 73U is performed using a second exposure apparatus 200b, and patterning 553 of the third layer 73T is performed using a third exposure apparatus 200c. Note that suffices a, b, and c are added to distinguish the exposure apparatuses 200 from each other. Suffices a, b, and c added to the individual information processing apparatuses PU are also added to distinguish the individual information processing apparatuses PU from each other.

A transfer condition for the patterning 551 of the first layer 73L can be provided from the first exposure apparatus 200a to a first individual information processing apparatus PUa or the shared information processing apparatus IPE. A transfer condition for the patterning 552 of the second layer 73U can be provided from the second exposure apparatus 200b to a second individual information processing apparatus PUb or the shared information processing apparatus IPE. The third exposure apparatus 200c that performs transfer for the patterning 553 of the third layer 73T can calculate relative position Δ between the first pattern P1 and the second pattern P2 in the detection step of the alignment step and provide it to a third individual information processing apparatus PUc or the shared information processing apparatus IPE. Alternatively, the third exposure apparatus 200c can provide an image of the mark 72 including the first pattern P1 and the second pattern P2 to the third individual information processing apparatus PUc or the shared information processing apparatus IPE. In this case, the third individual information processing apparatus PUc or the shared information processing apparatus IPE can calculate the relative position Δ between the first pattern P1 and the second pattern P2 based on the image. If the third individual information processing apparatus PUc calculates the relative position Δ, the third individual information processing apparatus PUc can provide the relative position Δ to the shared information processing apparatus IPE.

Based on the relative position Δ, the shared information processing apparatus IPE can determine an offset value that should be set in at least one of the first exposure apparatus 200a and the second exposure apparatus 200b. The offset value is determined to reduce the overlay error between the first layer 73L, the second layer 73U, and the third layer 73T. When setting offset values in both the first exposure apparatus 200a and the second exposure apparatus 200b, the offset values set in these can have values different from each other.

As for the offset value, an offset value used to adjust the patterning operation in the lithography apparatus (here, the exposure apparatus) can be determined (adjusted) in accordance with, for example, equation A below.

$$\text{equation A}: \text{OFS} = \Delta \times \beta \times \alpha$$

where Δ is the relative position between the first pattern P1 and the second pattern P2, $\alpha$ is the correction magnification, $\beta$ is the device coefficient, and OFS is the offset value.

If the offset value OFS exceeds a reference value, the shared information processing apparatus IPE can operate to set the offset value OFS in at least one of the first exposure apparatus 200a and the second exposure apparatus 200b. The device coefficient $\beta$ may be a variable determined in accordance with, for example, the position of a shot region, the order of a shot region that is to be processed on the substrate, or the order of a shot region that is to be exposed in the exposure apparatus.

The offset value OFS may be determined by the third individual information processing apparatus PUc and set in at least one of the first exposure apparatus 200a and the second exposure apparatus 200b by the third individual information processing apparatus PUc.

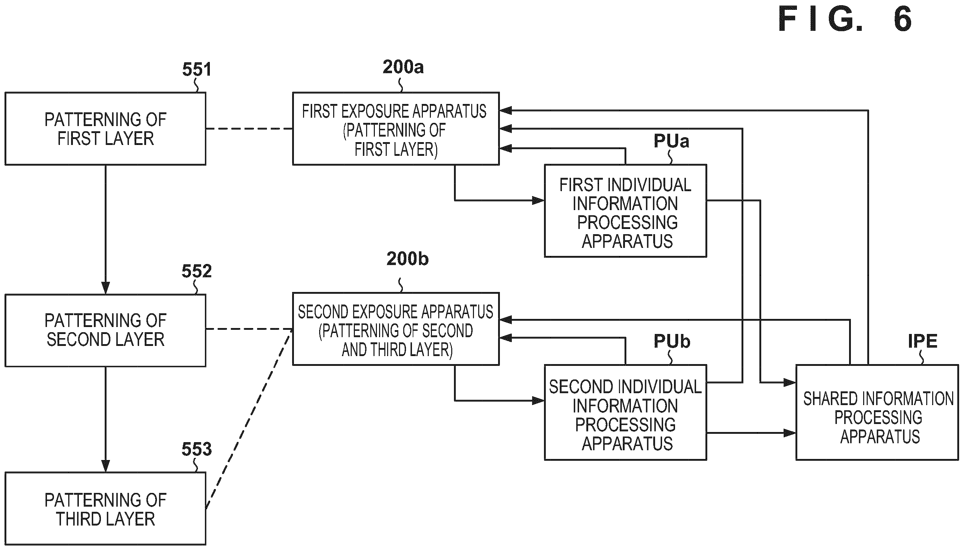

Fig. 6 schematically shows a second example of the operation of the lithography method including patterning of the first layer, the second layer, and the third layer. In the second example, the patterning 551 of the first layer 73L is performed using the first exposure apparatus 200a, the patterning 552 of the second layer 73U and the patterning 553 of the third layer 73T are performed using the second exposure apparatus 200b.

The transfer condition for the patterning 551 of the first layer 73L can be provided from the first exposure apparatus 200a to the first individual information processing apparatus PUa or the shared information processing apparatus IPE. The transfer condition for the patterning 552 of the second layer 73U can be provided from the second exposure apparatus 200b to the second individual information processing apparatus PUb or the shared information processing apparatus IPE. The second exposure apparatus 200b that performs transfer for the patterning 553 of the third layer 73T can calculate the relative position $\Delta$ between the first pattern P1 and the second pattern P2 in the detection step of the alignment step and provide it to the second individual information processing apparatus PUb or the shared information processing apparatus IPE. Alternatively, the second exposure apparatus 200b can provide an image of the mark 72 including the first pattern P1 and the second pattern P2 to the second individual information processing apparatus PUb or the shared information processing apparatus IPE. In this case, the second individual information processing apparatus PUb or the shared information processing apparatus IPE can calculate the relative position $\Delta$ between the first pattern P1 and the second pattern P2 based on the image. If the second individual information processing apparatus PUb calculates the relative position $\Delta$, the second individual information processing apparatus PUb can provide the relative position $\Delta$ to the shared information processing apparatus IPE.

Based on the relative position $\Delta$, the shared information processing apparatus IPE can determine the offset value OFS that should be set in at least one of the first exposure apparatus 200a and the second exposure apparatus 200b. The offset value is determined to reduce the overlay error between the first layer 73L, the second layer 73U, and the third layer 73T. When setting offset values OFS in both the first exposure apparatus 200a and the second exposure apparatus 200b, the offset values OFS set in these can have values different from each other.

If the offset value OFS exceeds a reference value, the shared information processing apparatus IPE can operate to set the offset value OFS in at least one of the first exposure apparatus 200a and the second exposure apparatus 200b. The offset value OFS may be determined by the second individual information processing apparatus PUb and set in at least one of the first exposure apparatus 200a and the second exposure apparatus 200b by the second individual information processing apparatus PUb.

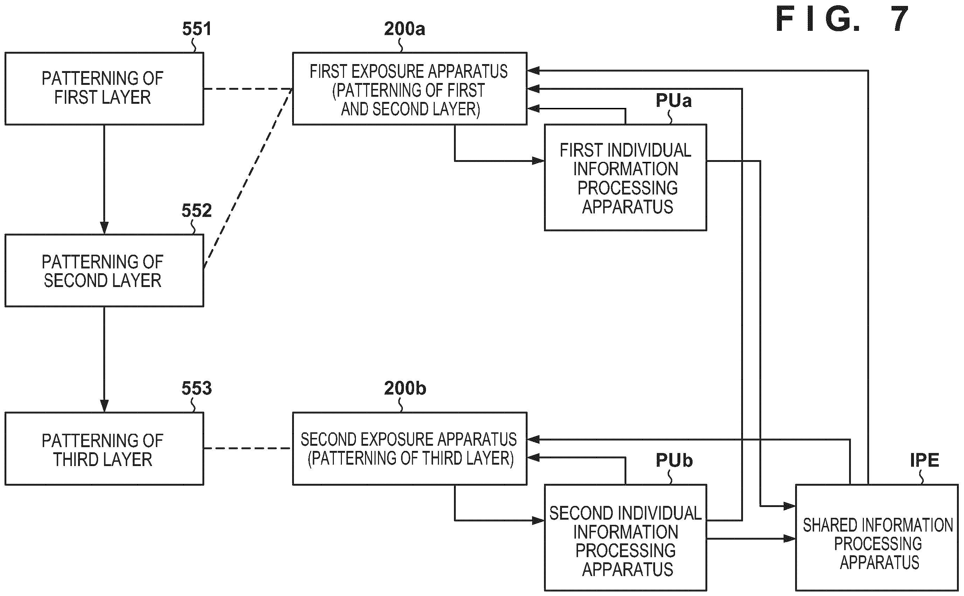

Fig. 7 schematically shows a third example of the operation of the lithography method including patterning of the first layer, the second layer, and the third layer. In the third example, the patterning 551 of the first layer 73L and the patterning 552 of the second layer 73U are performed using the first exposure apparatus 200a, and the patterning 553 of the third layer 73T is performed using the second exposure apparatus 200b.

The transfer condition for the patterning 551 of the first layer 73L can be provided from the first exposure apparatus 200a to the first individual information processing apparatus PUa or the shared information processing apparatus IPE. The transfer condition for the patterning 552 of the second layer 73U can be provided from the first exposure apparatus 200a to the first individual information processing apparatus PUa or the shared information processing apparatus IPE. The second exposure apparatus 200b that performs transfer for the patterning 553 of the third layer 73T can calculate the relative position $\Delta$ between the first pattern P1 and the second pattern P2 in the detection step of the alignment step and provide it to the second individual information processing apparatus PUb or the shared information processing apparatus IPE. Alternatively, the second exposure apparatus 200b can provide an image of the mark 72 including the first pattern P1 and the second pattern P2 to the second individual information processing apparatus PUb or the shared information processing apparatus IPE. In this case, the second individual information processing apparatus PUb or the shared information processing apparatus IPE can calculate the relative position $\Delta$ between the first pattern P1 and the second pattern P2 based on the image. If the second individual information processing apparatus PUb calculates the relative position $\Delta$, the second individual information processing apparatus PUb can provide the relative position $\Delta$ to the shared information processing apparatus IPE.

Based on the relative position $\Delta$, the shared information processing apparatus IPE can determine the offset value OFS that should be set in the first exposure apparatus 200a. The offset value is determined to reduce the overlay error between the first layer 73L, the second layer 73U, and the third layer 73T.

If the offset value OFS exceeds a reference value, the shared information processing apparatus IPE may operate to set the offset value OFS in the first exposure apparatus 200a. The offset value OFS may be determined by the second individual information processing apparatus PUb and set in the first exposure apparatus 200a by the second individual information processing apparatus PUb.

(Second Embodiment)

The second embodiment will be described below. An exposure apparatus 200, a position measurement device 120, and an example of the array of a plurality of shot regions of a substrate 83 described with reference to Figs. 1A, 1B, 2A, and 2B are applied in the second embodiment. An example of the configuration of a mark 72 shown in Figs. 3A and 3B is also applied in the second embodiment.

As described in the first embodiment, a first pattern P1 and a second pattern P2 can be arranged to be simultaneously fitted in the visual field of the position measurement device 120 (alignment scope). The mark 72 serves as an alignment mark configured to align an original 31 used for patterning of a third layer 73T on a second layer 73U. The target of alignment of the original 31 used for patterning of the third layer 73T may be a first layer 73L or the second layer 73U, or may be the first layer 73L and the second layer 73U. In the example shown in Figs. 3A and 3B, the first pattern P1 arranged in the first layer 73L includes, for example, four mark elements P1a, P1b, P1c, and P1d, and the second pattern P2 arranged in the second layer 73U includes four mark elements P2a, P2b, P2c, and P2d.

Only a part of the mark 72 may be used as the alignment mark for alignment of the original 31 used for patterning of the third layer 73T. For example, only the first pattern P1 of the mark 72 may be used as the alignment mark for alignment of the original 31 used for patterning of the third layer 73T, and in this case, the target of alignment of the original 31 is the first layer 73L. Alternatively, only the second pattern P2 of the mark 72 may be used as the alignment mark for alignment of the original 31 used for patterning of the third layer 73T, and in this case, the target of alignment of the original 31 is the second layer 73U.

Alternatively, both the first pattern P1 and the second pattern P2 may be used as the alignment mark for alignment of the original 31 used for patterning of the third layer 73T. In this case, the target of alignment of the original 31 includes the first layer 73L and the second layer 73U. Here, between the first pattern P1 and the second pattern P2, there can exist a substantial amount of position deviation (an amount of deviation from a design value) that occurs when forming the second pattern P2. Hence, if the position of the second pattern P2 is used to determine the position of the mark 72, an error may occur. A controller CU may perform conversion processing of converting the position of the second pattern P2 into the position of the second pattern P2 in a case where the second pattern P2 is formed without any position deviation with respect to the first pattern P1. The conversion processing can be performed based on relative position information indicating the position deviation amount (relative position) between the first pattern P1 and the second pattern P2. Hence, the second pattern P2 can be used as a part of the mark 72. If relative position information obtained by measurement does not exist yet, relative position information determined based on design information can be used for the conversion processing. On the other hand, if relative position information is obtained by measurement, the relative position information obtained by the measurement can be used for the conversion processing.

Here, let (Bx, By) be the measured position of the second pattern P2, and (Cx, Cy) be the relative position information indicating the relative position (position deviation amount) between the first pattern P1 and the second pattern P2. In this case, a position (Dx, Dy) of the second pattern P2 in a case where the second pattern P2 is formed without having a position deviation with respect to the first pattern P1, that is, the result of conversion processing can be represented by $(Dx, Dy) = (Bx - Cx, By - Cy)$. Also, a position (Ex, Ey) of the mark 72 can be represented by $(Ex, Ey) = ((Ax + Dx)/2, (Ay + Dy)/2)$.

The mark 72 serves as an overlay measurement mark configured to detect relative position information, that is, measure an overlay error. For example, the mark 72 can be used for a detection step of detecting the relative position information between the first pattern P1 and the second pattern P2 in an alignment step of aligning the substrate 83 and the original 31 for patterning of the third layer 73T. Alternatively, a detection step may be executed after the alignment step based on an image obtained by capturing an image of the first pattern P1 and the second pattern P2 in the alignment step of aligning the substrate 83 and the original 31 for patterning of the third layer 73T. The detection step can be performed to detect the relative position information between the first pattern P1 and the second pattern P2 in the exposure apparatus 200 or another apparatus. In this case as well, processing of capturing an image of the overlay measurement mark in an overlay measurement apparatus different from the exposure apparatus after patterning of the third layer is unnecessary, as in a conventional method. The other apparatus can be an individual information processing apparatus PU that is a dedicated information processing apparatus connected to the exposure apparatus 200, or a shared information processing apparatus IPE that is an information processing apparatus shared by a plurality of exposure apparatuses 200. Note that the individual information processing apparatus PU may be understood as a constituent element of the exposure apparatus 200.

Using the mark 72 not only as an alignment mark but also as an overlay measurement mark is advantageous in detecting an overlay error while suppressing cost. This is also advantageous in reducing an overcrowded state of marks on scribe lines or making the width of a scribe line small and improving yield.

In the mark 72, the first pattern P1 can include a plurality of first portions 301, and the second pattern P2 can include a plurality of second portions 302. In one viewpoint, the overlay measurement mark can have a feature that the second pattern P2 is fitted in a rectangular region 300 circumscribed on the first pattern P1. In another viewpoint, in the mark 72, at least a part of at least one of the plurality of second portions 302 can be arranged between at least two first portions 301 of the plurality of first portions 301.

In the alignment step, the position measurement device 120 can execute position measurement of the mark 72 for alignment of the original 31 for at least one of the first layer 73L and the second layer 73U. Also, in the alignment step, the position measurement device 120 can execute the detection step of detecting the relative position between the first pattern P1 and the second pattern P2. Alternatively, the position measurement device 120 may provide the image of the mark 72 captured in the alignment step to another apparatus (for example, the individual information processing apparatus PU or the shared information processing apparatus IPE) to allow the other apparatus to execute the detection step.

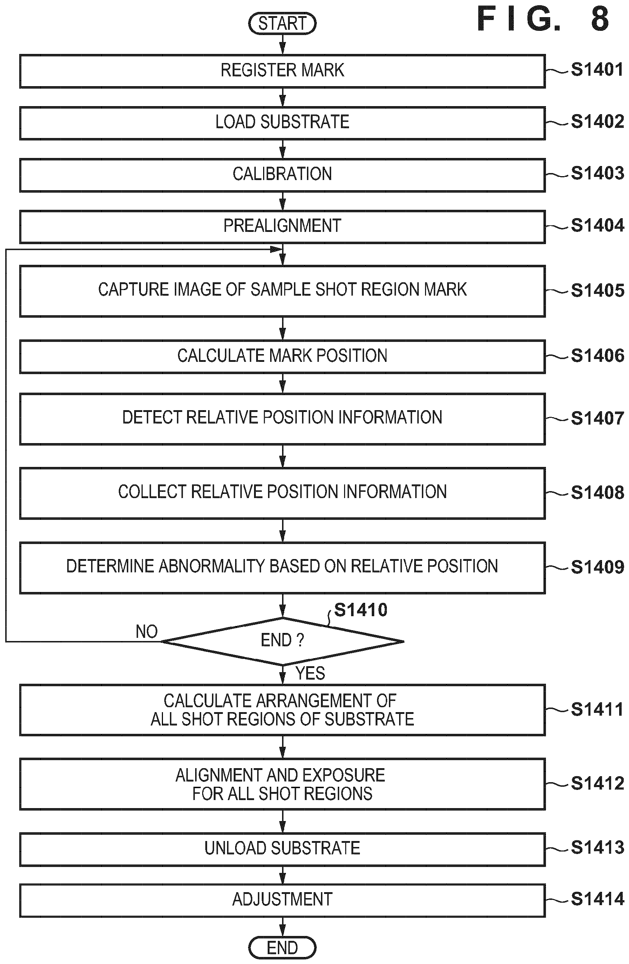

Fig. 8 exemplifies a lithography method for performing exposure for patterning of the third layer 73T (exposure of a photoresist film on the third layer) of the substrate 83 including the unpatterned third layer 73T on the first layer 73L and the second layer 73U which are patterned. Step S1401 is a registration step. In the registration step, the first pattern P1 and the second pattern P2, whose relative position information should be detected in the detection step (step S1405 and S1407) of the alignment step (step S1405 to S1412), are registered in the exposure apparatus 200 used for patterning of the third layer 73T. The registration step may include a step of registering a mark (the first pattern P1 and/or the second pattern P2) used for alignment between the substrate 83 and the original 31 in the alignment step. In the registration step, as the first pattern P1 and the second pattern P2, marks arranged to be simultaneously fitted in the visual field of the position measurement device 120 (alignment scope) in the exposure apparatus 200 used for patterning of the third layer 73T can be registered. The registration step can be executed by the controller CU, the individual information processing apparatus PU, or the shared information processing apparatus IPE.

In step S1402, the substrate 83 is loaded onto a substrate stage WS of the exposure apparatus 200 under the control of the controller CU. In step S1403, calibration is performed under the control of controller CU. More specifically, based on the designed coordinate position of the reference mark provided on a reference plate 39 on the coordinate system of the substrate stage WS, the substrate stage WS is driven such that the reference mark is located on the optical axis of the position measurement device 120. Next, the position deviation of the reference mark with respect to the optical axis of the position measurement device 120 is measured, and based on the position deviation, the coordinate system of the substrate stage WS is set again such that the origin of the coordinate system of the substrate stage WS matches the optical axis of the position measurement device 120. Next, based on the designed positional relationship between the optical axis of the position measurement device 120 and the optical axis of a projection optical system 32, the substrate stage WS is driven such that the reference mark is located on the optical axis of exposure light. Then, a through-the-lens (TTL) measurement system (not shown) measures, via the projection optical system 32, the position deviation of the reference mark with respect to the optical axis of the exposure light. Based on the result above, a baseline that is the interval between the optical axis of the position measurement device 120 and the optical axis of the projection optical system 32 is determined.

In step S1404, prealignment of the substrate 83 can be executed under the control of the controller CU. Prealignment is performed using, for example, a scope (not shown) having a visual field wider than that of the position measurement device 120, and the mark 72 can thus be fitted in the visual field of the position measurement device 120. In steps S1405 to S 1412, an alignment step (global alignment step) can be executed under the control of the controller CU. More specifically, in step S1405, the position measurement device 120 captures an image of the mark 72 in a preset sample shot region among all shot regions of the substrate 83. In step S1406, the controller CU can calculate (determine) the position of the mark 72 based on the image of the mark 72 captured in step S1405. The position of the mark 72 can be determined based on at least one of the position of the first pattern P1 and the position of the second pattern P2. When determining the position of the mark 72 based on both the position of the first pattern P1 and the position of the second pattern P2, the position of the mark 72 can be determined based on, for example, not only the position of the first pattern P1 and the position of the second pattern P2 but also preset relative position information.

Steps S1405 and S1407 form a detection step in the alignment step. In step S1407, the controller CU can detect the relative position information between the first pattern P1 and the second pattern P2 based on the image of the mark 72 captured in step S1405. Step S1407 may be executed by the individual information processing apparatus PU or the shared information processing apparatus IPE by transferring the image of the mark 72 captured in step S1405 to the individual information processing apparatus PU or the shared information processing apparatus IPE. The individual information processing apparatus PU and the shared information processing apparatus IPE can each be formed by, for example, a computer including a CPU and a memory. Each of the individual information processing apparatus PU and the shared information processing apparatus IPE can operate as an apparatus having a target function by loading a computer program into the memory and operating in accordance with the computer program. Each of the individual information processing apparatus PU and the shared information processing apparatus IPE can be understood as an information processing apparatus that executes an information processing method including step S1407 (detection step) based on the image of the mark 72 captured in step S1405. The information processing method may further include step S 1401 (registration step). Also, the information processing method may further include step S1414 (adjustment step) to be described later.

In step S1408, the controller CU can store the relative position information in a memory (not shown). The memory may be provided in the exposure apparatus 200 (for example, the controller CU), or may be provided in one of the individual information processing apparatus PU and the shared information processing apparatus IPE. Step S 1408 can be understood as a collection step of collecting relative position information. In step S1409, the controller CU can determine occurrence of an abnormality based on the relative position information collected in step S 1408 (collection step). Step S1409 can be understood as a determination step of determining occurrence of an abnormality. In an example, if the evaluation value of relative position (overlay error) indicated by the relative position information exceeds a threshold, it can be determined that an abnormality occurs. For example, if a variation such as the standard deviation of the relative position obtained for each of the plurality of sample shot regions exceeds a threshold, it can be determined that an abnormality occurs. Upon determining that an abnormality occurs, processing for eliminating the abnormality, for example, processing of adjusting an offset value can be performed.

In step S1410, the controller CU judges whether steps S1405 to S1409 are executed for all the plurality of preset sample shot regions. If there remains a sample shot region for which steps S1405 to S1409 have not been executed, the controller CU executes steps S1405 to S1409 for the sample shot region.

In step S1411, the controller CU performs global alignment of calculating the arrangement of all shot regions of the substrate 83 based on the position of the mark 72 calculated in step S1406 for the plurality of preset sample shot regions. In step S1412, the controller CU aligns each shot region of the substrate 83 and the original 31 based on the result of global alignment in step S1411, and exposes the shot region (transfers the pattern of the original). At this time, alignment between the substrate 83 (shot region) and the original 31 can be performed based on at least one of the position of the first pattern P1 and the position of the second pattern P2. In step S1413, the substrate 83 is unloaded under the control of the controller CU. When performing processing for a lot formed by a plurality of substrates 83 as a unit, steps S1402 to S1413 can be executed for the plurality of substrates.

Step S1414 can be executed by the individual information processing apparatus PU or the shared information processing apparatus IPE. In step S1414, an adjustment step of adjusting at least one of the lithography apparatus used for patterning of the first layer 73L and the lithography apparatus used for patterning of the second layer 73U can be executed based on the relative position information collected in step S1409. In the adjustment step, simply, adjustment information for adjusting at least one of the lithography apparatus used for patterning of the first layer and the lithography apparatus used for patterning of the second layer may be generated based on the relative position information collected in step S1409. In this case, the lithography apparatus can be adjusted based on the adjustment information at an arbitrary timing. The adjustment step can be executed to reduce the overlay error between the first layer 73L, the second layer 73U, and the third layer 73T. In the adjustment step, an offset value used to adjust a patterning operation in at least one of the lithography apparatus used for patterning of the first layer 73L and the lithography apparatus used for patterning of the second layer 73U can be adjusted.

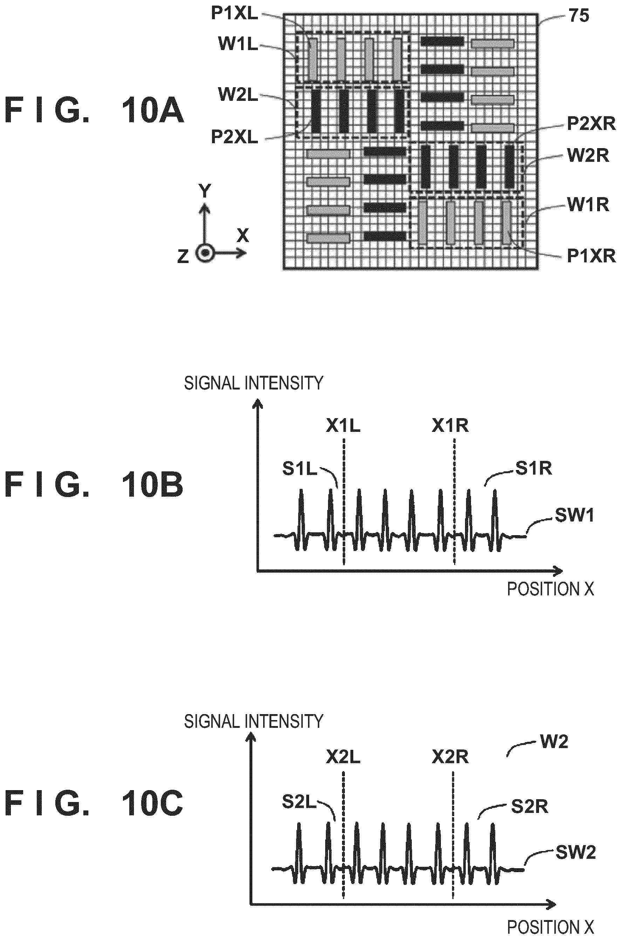

Processing of detecting the position of the mark 72 based on the position of the first pattern P1 and the position of the second pattern P2 in step S1406 will now be described with reference to Figs. 10A to 10C. Fig. 10A exemplifies an optical image of the mark 72 formed on the image capturing region (the visual field of the position measurement device 120) of an image sensor 75 of the position measurement device 120. A two-dimensional image sensor including the image capturing region formed by a plurality of pixels arrayed in the X direction and the Y direction can be used as the image sensor 75. Based on an output (captured image) from the image sensor 75, the controller CU can generate a detection signal including the waveforms corresponding to the first pattern P1 and the second pattern P2.

Fig. 10B exemplifies a detection signal SW1 generated when an evaluation region for evaluating the position of the first pattern P1 in the X direction is set with respect to the captured image obtained by capturing the mark 72 by the image sensor 75. Fig. 10C exemplifies a detection signal SW2 of the second pattern P2 generated when an evaluation region for evaluating the position of the second pattern P2 in the X direction is set with respect to the captured image obtained by capturing the mark 72 by the image sensor 75.

Based on the designed position of the mark 72, the controller CU can set evaluation regions W1L and W1R to include first portions P1XL and P1XR that are portions of the first pattern P1, respectively. Based on the designed position of the mark 72, the controller CU can set evaluation regions W2L and W2R to include second portions P2XL and P2XR that are portions of the second pattern P2, respectively. Each of the detection signals SW1 and SW2 can be generated by, for example, integrating the signal intensities of the respective pixels in the set evaluation regions in the Y direction. Note that with respect to the integration of the signal intensities of the respective pixels of the image sensor 75, the number of pixels to be integrated is preferably set based on the dimension information of the mark 72.

As exemplified in Fig. 10B, a waveform S1L included in the detection signal SW1 corresponds to the signal intensity of the first portion P1XL of the first pattern P1, and a waveform S1R corresponds to the signal intensity of the first portion P1XR of the first pattern P1. The controller CU obtains a measurement value X1L indicating the central position of the first portion P1XL from the waveform S1L, and obtains a measurement value X1R indicating the central position of the first portion P1XR from the waveform S1R. Based on the measurement values X1L and X1R, the controller CU determines information indicating the position of the first pattern P1 in the X direction. Fig. 10C is a view showing the detection signal SW2 of the second pattern P2. The controller CU can determine information indicating the position of the second pattern P2 in the X direction by the same measurement processing. With respect to the Y direction as well, the same measurement processing is executed for the first pattern P1 and the second pattern P2, and the controller CU can determine information indicating the positions of the first pattern P1 and the second pattern P2 in the Y direction.

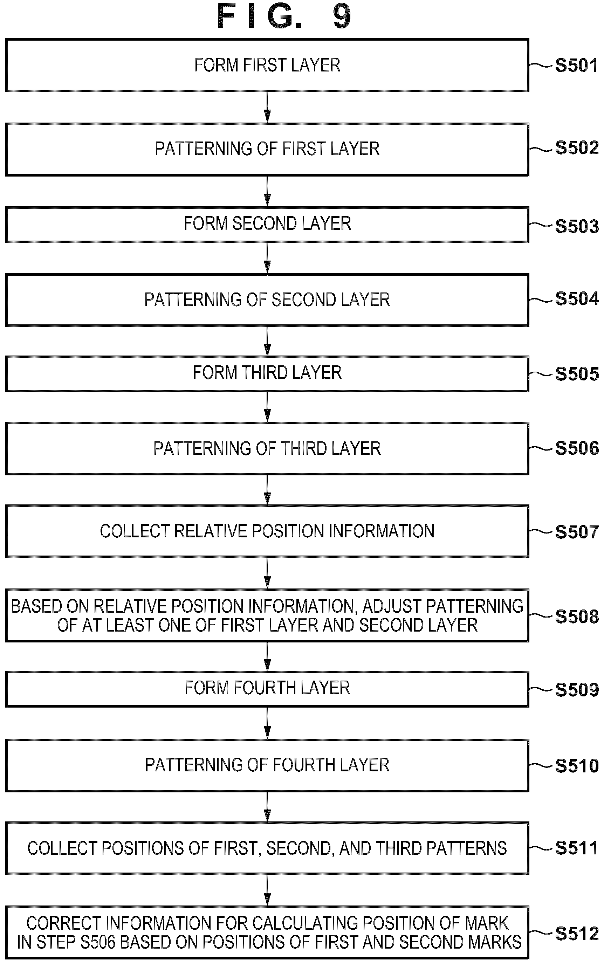

Fig. 9 exemplarily shows a procedure of a lithography method of forming a plurality of layers on a substrate according to the second embodiment. In step S501, the first layer 73L is formed on the substrate 83. In step S502, the first layer 73L is patterned by a first patterning step including a first pattern transfer step by the exposure apparatus 200. At this time, the first pattern P1 is formed in the first layer 73L together with the device pattern of the first layer.

In step S503, the second layer 73U is formed on the first layer 73L of the substrate 83. In step S504, the second layer 73U is patterned by a second patterning step including a second pattern transfer step by the exposure apparatus 200. At this time, the second pattern P2 is formed in the second layer 73U together with the device pattern of the second layer.

In step S505, the third layer 73T is formed on the second layer 73U of the substrate 83. In step S506, the third layer 73T is patterned by a third patterning step including a third pattern transfer step by the exposure apparatus 200. At this time, a third pattern P3 is formed in the third layer 73T together with the device pattern of the third layer. Also, in the third pattern transfer step of step S506, an alignment step of aligning the original 31 with the substrate 83 is executed. In the alignment step, the position of the mark 72 can be determined using the positions of both the first pattern P1 and the second pattern P2 forming the mark 72 and already prepared relative position information. At this time, the position of the second pattern P2 obtained from the image of the mark 72 can be converted into the position of the second pattern P2 in a case where the second pattern P2 is formed without any position deviation with respect to the first pattern P1 (conversion processing). Also, in the alignment step, to obtain latest relative position information, a detection step of detecting the relative position information between the first pattern P1 and the second pattern P2 based on the image of the mark 72 can be executed.

In step S507, the relative position information obtained in step S506 is collected. In step S508, an adjustment step of adjusting at least one of the lithography apparatus used for patterning of the first layer and the lithography apparatus used for patterning of the second layer can be executed based on (the evaluation result of) the relative position information collected in step S507.

In step S509, a fourth layer is formed on the third layer 73T of the substrate 83. In step S510, the fourth layer is patterned by a fourth patterning step including a fourth pattern transfer step by the exposure apparatus 200. At this time, a fourth pattern is formed in the fourth layer together with the device pattern of the fourth layer. Also, in the fourth pattern transfer step of step S510, for example, an alignment step of aligning the original 31 with the substrate 83 is executed using the mark 72 including the first pattern P1 of the first layer and the second pattern P2 of the second layer as an alignment mark. In the alignment step, a second detection step of detecting the position information of the first pattern P1 of the first layer, the second pattern P2 of the second layer, and the third pattern P3 of the third layer can be executed.

In step S511, the position information obtained in step S510 is collected. In step S512, the relative position information (the relative position information between the first pattern P1 and the second pattern P2) to be used in step S506 can be corrected based on (the result of evaluating) the position information obtained in step S510 (second detection step) and collected in step S511. When executing the lithography method shown in Fig. 5 for the next substrate (second substrate), the corrected relative position information is used in step S506. The correction of the relative position information can be executed to reduce the overlay error of the third layer with respect to the first layer and the second layer.

In the second embodiment, the alignment step is executed for the first layer or the second layer as the target layer based on the position of the mark 72 including the first pattern P1 and the second pattern P2. In the alignment step, the detection step of detecting the relative position between the marks P1 and P2 is executed. In the detection step, the relative position between the first pattern P1 of the first layer, the second pattern P2 of the second layer, and the third pattern P3 of the third layer may be detected, as will be described later.

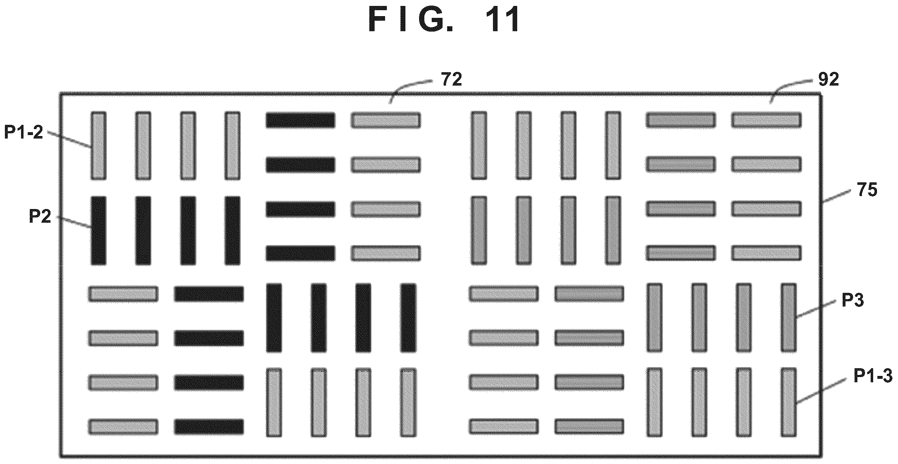

Fig. 11 shows an example in which first patterns P1-2 and P1-3 of the first layer, the second pattern P2 of the second layer, and the third pattern P3 of the third layer fit in the image capturing region of the image sensor 75. In the example shown in Fig. 11, the optical images of the first mark 72 and a second mark 92 fit in the image capturing region of the image sensor 75, the first mark 72 includes the first pattern P1-2 and the second pattern P2, and the second mark 92 includes the first pattern P1-3 and the third pattern P3.

(Article Manufacturing Method)

An article manufacturing method of manufacturing an article using the lithography method according to the first or second embodiment will exemplarily be described below. The article can be, for example, a device such as a semiconductor device, a display device, or a microdevice (for example, MEMS). The article manufacturing method can include a lithography step of forming a plurality of layers (a first layer 73L, a second layer 73U, and a third layer 73T) by the above-described lithography method, and a processing step of processing a substrate that has undergone the lithography step, thereby obtaining an article. The processing step can include, for example, an etching step, an annealing step, a film deposition step, a dicing step, and a sealing step.

This specification and the drawings include the following disclosure.

(Item 1)

A lithography method of forming, on a substrate, a plurality of layers including a first layer including a first pattern, a second layer including a second pattern, and a third layer, characterized by comprising:

    a detection step of detecting relative position between the first pattern and the second pattern in an alignment step of the substrate and an original for patterning of the third layer; and
    an adjustment step of adjusting at least one of a lithography apparatus used for patterning of the first layer and a lithography apparatus used for patterning of the second layer based on a result obtained in the detection step.

(Item 2)

The lithography method according to Item 1, characterized in that
the adjustment step is executed to reduce an overlay error between the first layer, the second layer, and the third layer.

(Item 3)

The lithography method according to Item 1 or 2, characterized in that
in the alignment step, the alignment between the substrate and the original is performed based on at least one of a position of the first pattern and a position of the second pattern.

(Item 4)

The lithography method according to any one of Items 1 to 3, characterized in that
in the adjustment step, an offset value used to adjust a patterning operation in at least one of the lithography apparatus used for patterning of the first layer and the lithography apparatus used for patterning of the second layer is adjusted.

(Item 5)

The lithography method according to any one of Items 1 to 4, characterized by further comprising a registration step of registering, in a lithography apparatus used for patterning of the third layer, the first pattern and the second pattern whose relative position should be detected in the detection step.

(Item 6)

The lithography method according to Item 5, characterized in that
the registration step includes a step of registering a mark to be used for the alignment between the substrate and the original in the alignment step.

(Item 7)

The lithography method according to Item 5 or 6, characterized in that
in the registration step, as the first pattern and the second pattern, marks arranged to be simultaneously fitted in a visual field of a position measurement device in the lithography apparatus used for patterning of the third layer are registered.

(Item 8)

The lithography method according to any one of Items 1 to 6, characterized in that
the first pattern and the second pattern are marks arranged to be simultaneously fitted in a visual field of a position measurement device in a lithography apparatus used for patterning of the third layer.

(Item 9)

The lithography method according to any one of Items 1 to 8, characterized in that
the lithography apparatus used for patterning of the first layer and the lithography apparatus used for patterning of the second layer are lithography apparatuses different from each other.

(Item 10)

The lithography method according to any one of Items 1 to 8, characterized in that
the lithography apparatus used for patterning of the first layer and the lithography apparatus used for patterning of the second layer are the same lithography apparatus.

(Item 11)

An article manufacturing method characterized by comprising:

a lithography step of forming a plurality of layers by a lithography method defined in any one of Items 1 to 10; and
a processing step of processing a substrate that has undergone the lithography step, thereby obtaining an article.

(Item 12)

An information processing method of processing information obtained in a lithography method of forming, on a substrate, a plurality of layers including a first layer including a first pattern, a second layer including a second pattern, and a third layer, characterized by comprising:

a detection step of detecting a position of the first pattern and a position of the second pattern based on an image obtained by capturing the first pattern and the second pattern in an alignment step of the substrate and an original for patterning of the third layer; and
an adjustment step of generating adjustment information used to adjust at least one of a lithography apparatus used for patterning of the first layer and a lithography apparatus used for patterning of the second layer based on a result obtained in the detection step.

(Item 13)

The information processing method according to Item 12, characterized in that
the adjustment step is executed to reduce an overlay error between the first layer, the second layer, and the third layer.

(Item 14)

The information processing method according to Item 12 or 13, characterized in that
in the alignment step, the alignment between the substrate and the original is performed based on at least one of a position of the first pattern and a position of the second pattern.

(Item 15)

The information processing method according to any one of Items 12 to 14, characterized in that
the adjustment information includes an offset value used to adjust a patterning operation in at least one of the lithography apparatus used for patterning of the first layer and the lithography apparatus used for patterning of the second layer.

(Item 16)

The information processing method according to any one of Items 12 to 15, characterized by further comprising
a registration step of registering, in a lithography apparatus used for patterning of the third layer, the first pattern and the second pattern whose relative position should be detected in the detection step.

(Item 17)

The information processing method according to Item 16, characterized in that
the registration step includes a step of registering a mark to be used for the alignment between the substrate and the original in the alignment step.

(Item 18)

The information processing method according to Item 16 or 17, characterized in that
in the registration step, as the first pattern and the second pattern, marks arranged to be simultaneously fitted in a visual field of a position measurement device in the lithography apparatus used for patterning of the third layer are registered.

(Item 19)

The information processing method according to any one of Items 12 to 18, characterized in that
the first pattern and the second pattern are marks arranged to be simultaneously fitted in a visual field of a position measurement device in a lithography apparatus used for patterning of the third layer.

(Item 20)

The information processing method according to any one of Items 12 to 19, characterized in that
the lithography apparatus used for patterning of the first layer and the lithography apparatus used for patterning of the second layer are lithography apparatuses different from each other.

(Item 21)

The information processing method according to any one of Items 12 to 19, characterized in that
the lithography apparatus used for patterning of the first layer and the lithography apparatus used for patterning of the second layer are the same lithography apparatus.

(Item 22)

A computer program configured to cause a computer to execute an information processing method defined in any one of Items 12 to 21.

(Item 23)

An information processing apparatus for processing information obtained in a lithography method of forming, on a substrate, a plurality of layers including a first layer including a first pattern, a second layer including a second pattern, and a third layer, characterized by comprising:

a detection step of detecting a position of the first pattern and a position of the second pattern based on an image obtained by capturing the first pattern and the second pattern in an alignment step of the substrate and an original for patterning of the third layer; and
an adjustment step of generating adjustment information used to adjust at least one of a lithography apparatus used for patterning of the first layer and a lithography apparatus used for patterning of the second layer based on a result obtained in the detection step.

(Item 24)

A lithography method of forming, on a substrate, a plurality of layers including a first layer including a first pattern, a second layer including a second pattern, and a third layer, characterized by comprising:

a detection step of detecting relative position information indicating relative position between the first pattern and the second pattern in an alignment step of the substrate and an original for patterning of the third layer; and
a collection step of collecting the relative position information obtained in the detection step.

(Item 25)

The lithography method according to Item 24, characterized in that
in the alignment step, the alignment between the substrate and the original is performed based on at least one of a position of the first pattern and a position of the second pattern.

(Item 26)

The lithography method according to Item 24 or 25, characterized by further comprising
an adjustment step of adjusting at least one of a lithography apparatus used for patterning of the first layer and a lithography apparatus used for patterning of the second layer based on the relative position information collected in the collection step.

(Item 27)

The lithography method according to Item 26, characterized in that
in the adjustment step, an offset value used to adjust a patterning operation in at least one of the lithography apparatus used for patterning of the first layer and the lithography apparatus used for patterning of the second layer is adjusted.

(Item 28)

The lithography method according to any one of Items 24 to 27, characterized by further comprising
a registration step of registering, in a lithography apparatus used for patterning of the third layer, the first pattern and the second pattern whose relative position information should be detected.

(Item 29)

The lithography method according to Item 5, characterized in that
the registration step includes a step of registering a mark to be used for the alignment between the substrate and the original in the alignment step.

(Item 30)

The lithography method according to Item 28, characterized in that
in the registration step, as the first pattern and the second pattern, marks arranged to be simultaneously fitted in a visual field of a position measurement device in the lithography apparatus used for patterning of the third layer are registered.

(Item 31)

The lithography method according to any one of Items 24 to 30, characterized in that
the first pattern and the second pattern are marks arranged to be simultaneously fitted in a visual field of a position measurement device in a lithography apparatus used for patterning of the third layer.

(Item 32)

The lithography method according to any one of Items 24 to 31, characterized by further comprising
a determination step of determining occurrence of an abnormality based on the relative position information collected in the collection step.

(Item 33)

The lithography method according to any one of Items 24 to 32, characterized in that

in the alignment step, the alignment between the substrate and the original is performed based on both the position of the first pattern and the position of the second pattern.

(Item 34)

The lithography method according to Item 33, characterized by further comprising

a formation step of forming a fourth layer on the third layer using a second original,
wherein the third layer includes a third pattern,
the formation step includes a second detection step of detecting position information of the first pattern, the second pattern, and the third pattern in a case of aligning the substrate and the second original,
the alignment step is executed for a second substrate in addition to the substrate, and
in the alignment step for the second substrate, the alignment between the second substrate and the original is performed based on both the position of the first pattern of the second substrate and the position of the second pattern of the second substrate and the position information obtained for the substrate in the second detection step.

(Item 35)

An article manufacturing method characterized by comprising:

a lithography step of forming a plurality of layers by a lithography method defined in any one of Items 24 to 34; and
a processing step of processing a substrate that has undergone the lithography step, thereby obtaining an article.

(Item 36)

An information processing method of processing information obtained in a lithography method of forming, on a substrate, a plurality of layers including a first layer including a first pattern, a second layer including a second pattern, and a third layer, characterized by comprising:

a detection step of detecting relative position information indicating relative position between the first pattern and the second pattern based on an image obtained by capturing the first pattern and the second pattern in an alignment step of the substrate and an original for patterning of the third layer; and
a collection step of collecting the information obtained in the detection step.

(Item 37)

The information processing method according to Item 36, characterized in that
in the alignment step, the alignment between the substrate and the original is performed based on at least one of a position of the first pattern and a position of the second pattern.

(Item 38)

The information processing method according to Item 36 or 37, characterized by further comprising an adjustment step of generating adjustment information used to adjust at least one of a lithography apparatus used for patterning of the first layer and a lithography apparatus used for patterning of the second layer based on the information collected in the collection step.

(Item 39)

The information processing method according to Item 38, characterized in that
in the adjustment step, an offset value used to adjust a patterning operation in at least one of the lithography apparatus used for patterning of the first layer and the lithography apparatus used for patterning of the second layer is adjusted.

(Item 40)

The information processing method according to any one of Items 36 to 39, characterized by further comprising
a registration step of registering, in a lithography apparatus used for patterning of the third layer, the first pattern and the second pattern whose relative position information should be detected.

(Item 41)

The information processing method according to Item 40, characterized in that
the registration step includes a step of registering a mark to be used for the alignment between the substrate and the original in the alignment step.

(Item 42)

The information processing method according to Item 40 or 41, characterized in that
in the registration step, as the first pattern and the second pattern, marks arranged to be simultaneously fitted in a visual field of a position measurement device in the lithography apparatus used for patterning of the third layer are registered.

(Item 43)

The information processing method according to any one of Items 36 to 42, characterized in that the first pattern and the second pattern are marks arranged to be simultaneously fitted in a visual field of a position measurement device in a lithography apparatus used for patterning of the third layer.

(Item 44)

The information processing method according to any one of Items 36 to 43, characterized by further comprising a determination step of determining occurrence of an abnormality based on the information collected in the collection step.

(Item 45)

The information processing method according to Item 44, characterized in that in the alignment step, the alignment between the substrate and the original is performed based on both a position of the first pattern and a position of the second pattern.

(Item 46)

The information processing method according to Item 45, characterized in that

the third layer includes a third pattern, a formation step of forming a fourth layer on the third layer using a second original further includes a second detection step of detecting position information of the first pattern, the second pattern, and the third pattern in a case of aligning the substrate and the second original,
the alignment step is executed for a second substrate in addition to the substrate, and
in the alignment step for the second substrate, the alignment between the second substrate and the original is performed based on both the position of the first pattern of the second substrate and the position of the second pattern of the second substrate and the position information obtained for the substrate in the second detection step.

(Item 47)

A computer program configured to cause a computer to execute an information processing method defined in any one of Items 36 to 46.

(Item 48)

An information processing apparatus for processing information obtained in a lithography method of forming, on a substrate, a plurality of layers including a first layer including a first pattern, a second layer including a second pattern, and a third layer, characterized in that the apparatus executes:

a detection step of detecting relative position information indicating relative position between the first pattern and the second pattern based on an image obtained by capturing the first pattern and the second pattern in an alignment step of the substrate and an original for patterning of the third layer; and
a collection step of collecting the information obtained in the detection step.

Other Embodiments

Embodiment(s) of the present invention can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)™), a flash memory device, a memory card, and the like.
While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A lithography method of forming, on a substrate, a plurality of layers including a first layer including a first pattern, a second layer including a second pattern, and a third layer, comprising:

   detecting relative position information indicating relative position between the first pattern and the second pattern in aligning the substrate and an original for patterning of the third layer; and collecting the relative position information obtained in the detecting.

2. The method according to claim 1, wherein in the aligning, the alignment between the substrate and the original is performed based on at least one of a position of the first pattern and a position of the second pattern.

3. The method according to claim 1, further comprising adjusting at least one of a lithography apparatus used for patterning of the first layer and a lithography apparatus used for patterning of the second layer based on the relative position information collected in the collecting.

4. The method according to claim 3, wherein in the adjusting, an offset value used to adjust a patterning operation in at least one of the lithography apparatus used for patterning of the first layer and the lithography apparatus used for patterning of the second layer is adjusted.

5. The method according to claim 3, wherein the adjusting is executed to reduce an overlay error between the first layer, the second layer, and the third layer.

6. The method according to any one of claims 3 to 5, wherein the lithography apparatus used for patterning of the first layer and the lithography apparatus used for patterning of the second layer are different from each other.

7. The method according to any one of claims 3 to 5, wherein the lithography apparatus used for patterning of the first layer and the lithography apparatus used for patterning of the second layer are the same.

8. The method according to any one of claims 1 to 7, further comprising registering, in a lithography apparatus used for patterning of the third layer, the first pattern and the second pattern whose relative position information should be detected.

9. The method according to claim 8, wherein the registering includes registering a mark to be used for the alignment between the substrate and the original in the aligning.

10. The method according to claim 8 or 9, wherein in the registering, as the first pattern and the second pattern, marks arranged to be simultaneously fitted in a visual field of a position measurement device in the lithography apparatus used for patterning of the third layer are registered.

11. The method according to any one of claims 1 to 7, wherein the first pattern and the second pattern are marks arranged to be simultaneously fitted in a visual field of a position measurement device in a lithography apparatus used for patterning of the third layer.

12. The method according to any one of claims 1 to 11, further comprising determining occurrence of an abnormality based on the relative position information collected in the collecting.

13. The method according to any one of claims 1 to 12, wherein in the aligning, the alignment between the substrate and the original is performed based on both the position of the first pattern and the position of the second pattern.

14. The method according to claim 13, further comprising forming a fourth layer on the third layer using a second original,

    wherein the third layer includes a third pattern, the forming includes detecting position information of the first pattern, the second pattern, and the third pattern in a case of aligning the substrate and the second original, the aligning is executed for a second substrate in addition to the substrate, and in the aligning for the second substrate, the alignment between the second substrate and the original is performed based on both the position of the first pattern of the second substrate and the position of the second pattern of the second substrate and the position information obtained for the substrate in the detecting the position information.

15. A lithography method of forming, on a substrate, a plurality of layers including a first layer including a first pattern, a second layer including a second pattern, and a third layer, comprising:

    detecting relative position between the first pattern and the second pattern in aligning the substrate and an original for patterning of the third layer; and adjusting at least one of a lithography apparatus used for patterning of the first layer and a lithography apparatus used for patterning of the second layer based on a result obtained in the detecting.

16. An article manufacturing method comprising:

forming a plurality of layers by the lithography method defined in any one of claims 1 to 15; and processing a substrate that has undergone the forming, thereby obtaining an article.

17. An information processing method of processing information obtained in a lithography method of forming, on a substrate, a plurality of layers including a first layer including a first pattern, a second layer including a second pattern, and a third layer, comprising:

detecting relative position information indicating relative position between the first pattern and the second pattern based on an image obtained by capturing the first pattern and the second pattern in aligning the substrate and an original for patterning of the third layer; and collecting the information obtained in the detecting.

18. An information processing method of processing information obtained in a lithography method of forming, on a substrate, a plurality of layers including a first layer including a first pattern, a second layer including a second pattern, and a third layer, comprising:

detecting a position of the first pattern and a position of the second pattern based on an image obtained by capturing the first pattern and the second pattern in aligning the substrate and an original for patterning of the third layer; and generating adjustment information used to adjust at least one of a lithography apparatus used for patterning of the first layer and a lithography apparatus used for patterning of the second layer based on a result obtained in the detecting.

19. A computer program including instructions that, when executed by a processor, perform the information processing method defined in claim 17 or 18.

20. An information processing apparatus for processing information obtained in a lithography method of forming, on a substrate, a plurality of layers including a first layer including a first pattern, a second layer including a second pattern, and a third layer, wherein the apparatus is configured to:

detect relative position information indicating relative position between the first pattern and the second pattern based on an image obtained by capturing the first pattern and the second pattern in aligning the substrate and an original for patterning of the third layer; and collect the information obtained in the detecting.

21. The apparatus according to claim 20, wherein the apparatus is further configured to:

detect a position of the first pattern and a position of the second pattern based on the image obtained by capturing the first pattern and the second pattern in the aligning the substrate and the original for patterning of the third layer; and generate adjustment information used to adjust at least one of a lithography apparatus used for patterning of the first layer and a lithography apparatus used for patterning of the second layer based on a result obtained in the detecting.

**F I G. 1A**

200

180

181

RS

31

32

CU

PU

IPE

IF

120

WS

39

Y

Z

X

# F I G. 1B

F I G. 2A

SAMPLE SHOT REGION

F I G. 2B

SAMPLE SHOT REGION

# F I G. 3A

# F I G. 3B

# F I G. 4

```
                    START

                   REGISTER                          S401

                LOAD SUBSTRATE                       S402

                 CALIBRATION                         S403

                PREALIGNMENT                         S404

     CAPTURE IMAGE OF SAMPLE SHOT REGION MARK        S405

              CALCULATE MARK POSITION                S406

            CALCULATE RELATIVE POSITION              S407

                                      S408
        NO           END ?

                      YES

           CALCULATE ARRANGEMENT OF                  S409
          ALL SHOT REGIONS OF SUBSTRATE

            ALIGNMENT AND EXPOSURE                   S410
             FOR ALL SHOT REGIONS

               UNLOAD SUBSTRATE                      S411

                  ADJUSTMENT                         S412

                    END
```

EP 4 498 157 A2

EP 4 498 157 A2

EP 4 498 157 A2

# FIG. 8

START

REGISTER MARK ~S1401

LOAD SUBSTRATE ~S1402

CALIBRATION ~S1403

PREALIGNMENT ~S1404

CAPTURE IMAGE OF SAMPLE SHOT REGION MARK ~S1405

CALCULATE MARK POSITION ~S1406

DETECT RELATIVE POSITION INFORMATION ~S1407

COLLECT RELATIVE POSITION INFORMATION ~S1408

DETERMINE ABNORMALITY BASED ON RELATIVE POSITION ~S1409

NO ◇ END ? ~S1410

YES

CALCULATE ARRANGEMENT OF
ALL SHOT REGIONS OF SUBSTRATE ~S1411

ALIGNMENT AND EXPOSURE
FOR ALL SHOT REGIONS ~S1412

UNLOAD SUBSTRATE ~S1413

ADJUSTMENT ~S1414

END

# F I G. 9

```
┌─────────────────────────────────────────────────┐
│              FORM FIRST LAYER                     │──S501
└─────────────────────────────────────────────────┘
                        │
                        ▼
┌─────────────────────────────────────────────────┐
│           PATTERNING OF FIRST LAYER               │──S502
└─────────────────────────────────────────────────┘
                        │
                        ▼
┌─────────────────────────────────────────────────┐
│              FORM SECOND LAYER                    │──S503
└─────────────────────────────────────────────────┘
                        │
                        ▼
┌─────────────────────────────────────────────────┐
│          PATTERNING OF SECOND LAYER               │──S504
└─────────────────────────────────────────────────┘
                        │
                        ▼
┌─────────────────────────────────────────────────┐
│              FORM THIRD LAYER                     │──S505
└─────────────────────────────────────────────────┘
                        │
                        ▼
┌─────────────────────────────────────────────────┐
│           PATTERNING OF THIRD LAYER               │──S506
└─────────────────────────────────────────────────┘
                        │
                        ▼
┌─────────────────────────────────────────────────┐
│        COLLECT RELATIVE POSITION INFORMATION      │──S507
└─────────────────────────────────────────────────┘
                        │
                        ▼
┌─────────────────────────────────────────────────┐
│ BASED ON RELATIVE POSITION INFORMATION, ADJUST    │
│ PATTERNING OF AT LEAST ONE OF FIRST LAYER AND     │──S508
│ SECOND LAYER                                      │
└─────────────────────────────────────────────────┘
                        │
                        ▼
┌─────────────────────────────────────────────────┐
│              FORM FOURTH LAYER                    │──S509
└─────────────────────────────────────────────────┘
                        │
                        ▼
┌─────────────────────────────────────────────────┐
│          PATTERNING OF FOURTH LAYER               │──S510
└─────────────────────────────────────────────────┘
                        │
                        ▼
┌─────────────────────────────────────────────────┐
│  COLLECT POSITIONS OF FIRST, SECOND, AND THIRD    │──S511
│  PATTERNS                                         │
└─────────────────────────────────────────────────┘
                        │
                        ▼
┌─────────────────────────────────────────────────┐
│ CORRECT INFORMATION FOR CALCULATING POSITION OF   │
│ MARK IN STEP S506 BASED ON POSITIONS OF FIRST     │──S512
│ AND SECOND MARKS                                  │
└─────────────────────────────────────────────────┘
```

FIG. 10A

P1XL
W1L
W2L
P2XL
75
P2XR
W2R
W1R
P1XR

Y
Z X

FIG. 10B

SIGNAL INTENSITY

X1L    X1R

S1L        S1R

SW1

POSITION X

FIG. 10C

SIGNAL INTENSITY

X2L    X2R    W2

S2L        S2R

SW2

POSITION X

FIG. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5194800 B